# EUROPÄISCHE PATENTSCHRIFT

(11) **EP 2 061 078 B1**
(45) Veröffentlichungstag und Bekanntmachung des Hinweises auf die Patenterteilung: **15.07.2015**
(21) Anmeldenummer: 07022269.0
(22) Anmeldetag: 16.11.2007
(51) Int. Cl.: H01L 23/473, H01L 21/48

(54) **Kühlkörper**
Cooling element
Corps de refroidissement

(43) Veröffentlichungstag der Anmeldung: 20.05.2009
(73) Patentinhaber: IQ evolution GmbH, 40212 Düsseldorf (DE)
(72) Erfinder: Ebert, Thomas, 52072 Aachen (DE); Hahn, Hermann, 40547 Düsseldorf (DE)
(74) Vertreter: Paul, Dieter-Alfred

(56) Entgegenhaltungen:
- EP-A- 0 468 467
- EP-A- 1 672 690
- DE-A1-102004 053 874
- FR-A- 2 841 805

## Beschreibung

Die vorliegende Erfindung betrifft einen Mikrokühlkörper mit einer Montagefläche für ein zu kühlendes Bauteil, insbesondere ein Halbleiterbauelement, welches im Inneren eine Mikrokühlsturktur aufweist, die über Verbindungskanäle mit mindestens einer Zulauföffnung und mindenstens einer Ablauföffnung verbunden ist, über die der Mikrokühlstruktur ein Kühlmedium zuführbar bzw. aus ihr abführbar ist. Ferner betrifft die vorliegende Erfindung ein Verfahren sowie eine Vorrichtung zur Herstellung eines solchen Mikrokühlkörpers.

Mikrokühlkörper der oben genannten Art sind bekannt und beispielsweise in der EP 1 672 690 beschrieben. Ziel des in dieser Druckschrift beschriebenen Mikrokühlkörpers ist es, eine verbesserte Wärmeabfuhr im Bereich der Montageflächen für elektronische Bauteile zu erreichen. Zur homogeneren Wärmeverteilung sollte eine Möglichkeit gefunden werden, die Mindestaußenwandstärken im Bereich der Montagefläche des zu kühlenden Bauteils zu verringern ohne Einbußen bezüglich der Sicherheit gegen Leckage hinnehmen zu müssen. Dies wird ermöglicht, indem der Kühlkörper mittels des selektiven Laserschmelzens hergestellt wird, und so eine monolitische Struktur aufweist, die gegenüber den schichtförmig aufgebauten Mikrokühlkörpern den Vorteil hat, dass bei Verringerung der Wandstärken die befürchteten Dichtigkeitsprobleme aufgrund von Fugen zwischen dem miteinander zu verschweißenden Schichten verringert sind. Ein weiterer Vorteil der Verwendung des selektiven Laserschmelzens bei der Herstellung des Kühlkörpers gemäß dem Stand der Technik besteht darin, dass mit diesem Verfahren auch komplexe Innenstrukturen beispielsweise in Form von ovalen Kanalquerschnitten innerhalb des Kühlkörpers hergestellt werden können.

Zur Realisierung bestimmter Eigenschaften des zu fertigenden Bauteils muss allerdings unter Abwägung der Vor- und Nachteile der einzelnen Werkstoffe eine Entscheidung bezüglich des zu verwendenden Materialpulvers erfolgen. Die Auswahl ist im bekannten Stand der Technik auf einen spezifischen Werkstoff oder eine entsprechende Werkstofflegierung zur Herstellung des gesamten Bauteils beschränkt. Dies erfordert eine Abschätzung, welche Materialeigenschaft für den Verwendungszweck des herzustellenden Bauteils entscheidend ist und bezüglich welcher Parameter aufgrund dessen Einschränkungen in Kauf genommen werden müssen. Die Auswahl nur eines Werkstoffes stellt somit grundsätzlich einen Kompromiss zwischen den innerhalb des Bauteils auch erheblich unterschiedlichen Anforderungen dar. Als Beispiel sei dazu ausgeführt, dass ein Mikrokühlkörper im Bereich des Durchflusses des Kühlmediums erosionsbeständige Eigenschaften haben sollte, im Bereich seiner äußeren Begrenzung hingegen eine extrem hohe mechanische Stabilität, im Bereich der Montagefläche für das zu kühlende Bauteil eine gute Wärmeleitfähigkeit und einen möglichst angepassten Ausdehnungskoeffizienten und eine Beständigkeit gegen Elektrokorrosion. Da kein Werkstoff oder Werkstofflegierung all diese Eigenschaften vereint, muss im Stand der Technik unter anderem auch aufgrund der durch den Abnehmer aufgezeigten Anforderungen entschieden werden, ob zugunsten der Kühlfähigkeit und der Erosionsbeständigkeit die Ausdehnungsanpassung an das zu kühlende Bauteil und die Beständigkeit gegen Elektrokorrosion in den Hintergrund gestellt werden soll oder umgekehrt.

Es ist daher die Aufgabe der vorliegenden Erfindung, einen Mikrokühlkörper bereitzustellen, der an die sich innerhalb des Bauteils wechselnden Anforderungen anpassbar ist.

Das Dokument FR 2 841 809 offenbart ein Verfahren zur Herstellung eines Verbundproduktes, insbesondere eines Kühlkörpers für elektronische Schaltungen, welche aus einem Metall wie beispielsweise Kupfer oder Silber in Kombination mit Kohlenstoffpartikeln hergestellt ist. Dazu wird zunächst das Metall aufgeschmolzen und schließlich mit den Kohlenstoffpartikeln versetzt. Dazu wird zunächst ein homogenes Gemisch aus Metallpulverpartikeln und Kohlenstoffpartikeln sowie ein in diese beiden Verbindungen Schmiermittel herstellt. Durch Kaltpressen wird aus dem Gemisch aus Pulver und Schmiermittel eine Platte hergestellt. Anschließend wird diese Platte erhitzt und mittels Heizschmiedens kompaktiert und verdichtet. Ein Mikrokühlkörper, der von einem Fluid wie beispielsweise Kühlwasser durchströmt werden soll, ist über eine solche Bandstruktur jedoch nicht herstellbar.

Auch das Dokument EP 0 468 467 B1 offenbart eine Verfahren zur Herstellung eines Sinterkörpers zur Verwendung als Präzisionseisenteils- wie Beispielsweise in Uhren. Zunächst wird eine homogene Mischung aus Eisenlegie,rungspulver und eines organischen Bindemittels, wobei das Metallpulver und das organische Bindemittel in einem geschmolzenen Zustand gemischt und geknetet wird, um eine homogene Mischung der Komponenten zu erhalten. Anschließend wird die Mischung in eine vorbestimmte Form durch ein bekanntes Verfahren geformt, wie beispielsweise mittels Spritzguss. Anschließend wird das organische Bindemittel entfernt. Allerdings weist der so erreichte Sinterkörper über seinen gesamten Querschnitt hinweg gleich ein Werkstoff mit identischen Materialeigenschaften auf.

Es ist daher die Aufgabe der vorliegenden Erfindung, einen Mikrokühlkörper bereitzustellen, der an die sich innerhalb des Bauteils wechselnden Anforderungen an das Material anpassbar ist. Diese Aufgabe wird erfindungsgemäß durch einen Mikrokühlkörper gemäß dem Anspruch 1, einer Vorrichtung zur Herstellung des Mikrokühlkörpers gemäß dem Anspruch 7 und ein Verfahren zur Herstellung des Mikrokühlkörpers gemäß Anspruch 13 gelost. Monolithisch im Sinne der Erfindung ist ein aus einem Stück bestehendes fugenloses zusammenhängendes Bauteil mit einer möglichst ununterbrochenen Gefügestruktur.

Mit anderen Worten basiert die Erfindung auf dem Grundgedanken, dass in Bereichen des Mikrokühlkörpers, in denen eine gute Wärmeleitfähigkeit, ein angepasster Ausdehnungskoeffizient und eine Beständigkeit gegen Elektrokorrosion als prominente Werkstoffeigenschaften bewertet werden, ein pulverförmiger oder flüssiger Werkstoff bzw. ein Werkstoffgemisch zum Einsatz kommt und zum Schichtaufbau genutzt wird, welcher bzw. welches diese Werkstoffeigenschaften aufweist, wohingegen in Bereichen, in denen Erosionsbeständigkeit des Materials wesentlich ist, ein durch diese Eigenschaften gekennzeichneter Werkstoff als Grundlage für die Schichtbildung in diesem Bereich eingesetzt wird.

Gleichzeitig wird durch den schichtweisen Aufbau und die damit verbundene Beibehaltung einer monolitischen Struktur des Bauteils eine Fugenbildung zwischen den verschiedenen Werkstoffen vermieden, was mit einer Verringerung der Dichtigkeitsproblematik einhergeht, so dass auch in einem solchen Kühlkörper gegenüber den Wandstärken bekannter Kupferwärmesenken die benötigte Mindestaußenwandstärke des Mikrokühlkörpers stark verringert werden kann, Dies führt dazu, dass auch hier eine wesentlich größere Überdeckung zwischen dem Bereich, durch den ein Kühlmedium wie beispielsweise destilliertes Wasser fließt, und der Montagefläche des zu kühlenden Bauteils erreicht wird, was mit einem homogeneren Wärmeaustausch und damit einer effektiveren Kühlung der elektronischen Bauelemente einhergeht.

Ein Weg, einen erfindungsgemäßen Mikrokühlkörper herzustellen, bietet das erfindungsgemäße Verfahren zur Herstellung eines Bauteils durch schichtweisen Aufbau aus mindestens zwei verschiedenartigen pulverförmigen und/oder flüssigen, insbesondere metallischen und/oder keramischen Werkstoffen, welches die Verfahrensschritte aufweist:
1. Einbringen eines Werkstoffes oder Werkstoffgemisches in einen Bearbeitungsbereich;
2. Verteilen des Werkstoffs auf dem Bearbeitungsbereich, insbesondere mittels einer Nivelliervorrichtung unter Bildung einer gleichmäßigen Schicht;
3. Bestrahlen des Bearbeitungsbereiches zur Aufschmelzung und Fixierung des Werkstoffes an der darunterliegenden Schicht;
4. Absenken des Bearbeitungsbereichs; und
5. Wiederholen der Schritte 1 bis 4.

Um nun die verschiedenen Bereiche entsprechend ihrer Beanspruchung aus unterschiedlichen Werkstoffen bzw. Werkstoffkombinationen ausbilden zu können, und dazu die verschiedenartigen Werkstoffe oder Werkstoffgemische dem Bearbeitungsbereich zuführen zu können, ist in dem erfindungsgemäßen Verfahren ein Speiser vorgesehen, welcher mehrere Materialkammern aufweist, die mit jeweils einem eine bestimmte Eigenschaft aufweisenden Werkstoff befüllbar und über eine Verbindungsleitung dem Bearbeitungsbereich zuführbar sind. Auslassseitig ist jede der Materialkammern jeweils eine Dosiereinheit zugeordnet, die es ermöglicht, ein Mischungsverhältnis und/oder eine Zuführmenge der verschiedenartigen Werkstoffe zu dem Bearbeitungsbereich einzustellen und insbesondere in einer nachgestalteten Mischkammer zu einem homogenen Gemisch zu vermengen. Dabei kann das Mischungsverhältnis der jeweiligen Werkstoffe in dem Werkstoffgemisch einen Wert zwischen 0 und 100% einnehmen, d.h. mit anderen Worten, dass zum einen die Zuführung verschiedener bereits vorgemischter Werkstoffe bzw. Werkstoffgemische über die Materialkammern möglich ist. Dazu können die Mischkammern mit Werkstoffgemischen mit abnehmendem Gewichtsanteil eines ersten Werkstoffes oder Werkstoffgemisches bei gleichzeitiger Zunahme des Gewichtsanteils eines zweiten Werkstoffes bestückt sein und nacheinander dem Bearbeitungsbereich zugeführt werden, indem die Dosiereinheiten die Zuführung durch Öffnen der einzelnen Materialkammern ermöglichen. Zum anderen können aber auch verschiedenartige Werkstoffe zunächst über die Dosiereinheiten aus den Materialkammern herausgeleitet und anschließend durch Vermengung insbesondere in einer nachgeschalteten Mischkammer erst die für den Verfahrensschritt notwendige Zusammensetzung des Werkstoffgemisches erstellt werden. Natürlich ist es auch insbesondere bei miteinander kompatiblen Werkstoffen möglich, zuerst den einen Werkstoff in seiner reinen Form zuzuführen und zu verarbeiten und anschließend den zweiten Werkstoff in den Bearbeitungsbereich einzuführen und unmittelbar auf den erstarrten ersten Werkstoff aufzubauen, ohne eine verlaufende Übergangszone zwischen den Werkstoffen auszubilden. Die letzte Variante hat den Vorteil, dass es zum einen möglich ist, die Werkstoffe in ihrer reinen Form zu verwenden, so dass nach Beendigung der Bauteile in den Materialkammern zurückgebliebenes Material in seiner reinen Form entnommen und so wieder gelagert werden kann. Im Gegensatz zu Werkstoffgemischen sind die Werkstoffe in reiner Form flexibler wiederverwendbar. Zum anderen kann eine viel feinere Abstufung der Zusammensetzung getroffen werden, da nicht für jede Zusammensetzung eine separate Materialkammer im Speiser vorgesehen werden muss.

Eine vorteilhafte Ausgestaltung des erfindungsgemäßen Verfahrens sieht vor, zur Schaffung eines homogenen Übergangs zwischen zwei verschiedenartigen Werkstoffen das Mischungsverhältnis der zuzuführenden Materialien vor der Zufuhr in den Bearbeitungsbereich von Schichtauftrag zu Schichtauftrag stufenweise oder kontinuierlich zu verändern. Die stufenweise Veränderung des Schichtauftrages ermöglicht, eine Übergangszone zwischen den beiden verschiedenartigen Werkstoffen zu schaffen, ohne dazu zwingend die Werkstoffe in einer Mischkammer zu vermengen. Vielmehr ist es möglich, durch die Erstellung eines Materialgemisches vor der Durchführung des Verfahrens und ein entsprechendes Befüllen der Mischkammern in dem Speiser durch ein stufenweises Zuführen zunächst des ersten reinen Werkstoffs, dann des spezifischen Werkstoffgemisches und schließlich des zweiten reinen Werkstoffes eine homogene Übergangszone zu schaffen. Diese Vorgehensweise ist besonders bei Werkstoffen geeignet, die zumindest eine geringe Kompatibilität zueinander aufweisen.

Eine alternative Ausbildung der Übergangszone stellt eine kontinuierliche Veränderung des Mischungsverhältnisses der zuzuführenden Werkstoffe dar. Durch die kontinuierliche Mischung der Materialien wird ein noch homogenerer Übergang geschaffen, mit dem es möglich ist, auch Materialien welche sich nicht oder nur sehr schlecht direkt verbinden lassen, in einem Bauteil zu verwenden.

In einer weiteren Ausführungsform des erfindungsgemäßen Verfahrens ist vorgesehen, zur Verbindung zweier verschiedenartiger, insbesondere miteinander völlig inkompatibler Werkstoffe einen Vermittlerwerkstoff einzusetzen, der ebenfalls zur Bildung einer Übergangszone kontinuierlich oder aber auch stufenweise über den Speiser zugeführt werden kann. Stufenweise heißt hier, dass nach dem Auftrag des ersten Werkstoffes zunächst eine reine Schicht des Vermittlerwerkstoffes aufgetragen wird und anschließend der zweite Werkstoff auf den Vermittlerwerkstoff aufgetragen wird. Kontinuierlich bedeutet, dass auch hier eine Vermengung des Vermittlerwerkstoffes mit dem ersten Werkstoff erzeugt wird und anschließend der Anteil des ersten Werkstoffes in dem Stoffgemisch von Schicht zu Schicht abnimmt und in gleicher Weise der Anteil des zweiten mit dem ersten Werkstoff inkompatiblen Werkstoffes in dem Gemisch immer weiter zunimmt. Natürlich ist auch denkbar, direkt ein Gemisch aus Vermittlerwerkstoff, dem ersten und dem zweiten Werkstoff zu erzeugen und auf die letzte Schicht des ersten Werkstoffes aufzubringen und anschließend den zweiten Werkstoff direkt auf die durch das Gemisch gebildete Schicht aufzubringen.

Wesentlich für eine homogene Ausbildung der Übergangszone ist eine genaue Dosierung der Mengenanteile der einzelnen Werkstoffkomponenten. Erfindungsgemäß wird für die Einstellung eines bestimmten Mischungsverhältnisses ein erfindungsgemäßer Speiser eingesetzt, der ein Gehäuse aufweist, in dem mindestens zwei Materialkammern ausgebildet sind, die mit jeweils einem Werkstoff oder einem Werkstoffgemisch befüllbar sind und denen auslassseitig jeweils eine Dosiereinheit zugeordnet ist. Über die Dosiereinheiten ist es möglich, ein Mischungsverhältnis und/oder die Zuführmenge der dem Bearbeitungsbereich zuzuführenden Werkstoffe oder Werkstoffgemische einzustellen. Um eine möglichst homogene Mischung zwischen den einzelnen Werkstoffen oder Werkstoffgemischen zu erhalten, schließt sich an dem erfindungsgemäßen Speiser auch in diesem Fall eine Mischkammer an.

Eine besonders genaue Einstellung eines vorgebbaren Mischungsverhältnisses kann erreicht werden, wenn die Dosiereinheiten des Speisers computergesteuert sind.

Der soeben beschriebene erfindungsgemäße Speiser kann entweder Teil einer Vorrichtung zur Herstellung eines Bauteils, insbesondere eines Mikrokühlkörpers durch schichtweisen Aufbau von mindestens zwei verschiedenartigen pulverförmigen und/oder flüssigen, insbesondere metallischem und/oder keramischen Werkstoffen oder Werkstoffgemischen sein, oder aber auch in bereits bestehende Vorrichtungen zur Herstellung eines Mikrokühlkörpers aus nur einem Material nachgerüstet werden, so dass auch diese Vorrichtungen in der Lage sind Mehrkomponentenbauteile mittels des selektiven Laserschmelzens herzustellen.

Eine erfindungsgemäße Vorrichtung zur Herstellung eines Bauteils, insbesondere eines Mikrokühlkörpers, durch schichtweisen Aufbau von mindestens zwei verschiedenartigen, pulverförmigen und/oder flüssigen, insbesondere metallischen und/oder keramischen Werkstoffen oder Werkstoffgemischen mit einer Bearbeitungskammer, in der ein Bearbeitungsraum ausgebildet ist, in dem die Werkstoffe oder Werkstoffgemische über mindestens einen Speiser einbringbar sind und mindestens einer Strahlungsquelle, deren Strahlung in den Bearbeitungsraum einkoppelbar ist, weist vorteilhafterweise ein Speiser mit mehreren Materialkammern auf, die mit jeweils einem Werkstoff oder Werkstoffgemisch befüllbar sind und denen auslassseitig jeweils eine Dosiereinheit zugeordnet ist, über die ein Mischungsverhältnis und/oder eine Zuführmenge der Werkstoffgemische zum Bearbeitungsraum einstellbar ist. Auch in dieser Vorrichtung kann den Dosiereinheiten zur homogenen Durchmischung des Werkstoffes oder des Werkstoffgemisches mindestens eine Mischkammer nachgeschaltet sein, wobei die Dosiereinheit zur genauen Einstellung eines vorgebbaren Mischungsverhältnisses auch computergesteuert sein können.

Um während des Verfahrens nicht bearbeiteten Werkstoff auch nach Abschluss der Herstellung des Bauteils bzw. Mikrokühlkörpers noch für weitere Bauteile verwenden zu können, sind in einem Ausführungsbeispiel der Erfindung in der Bearbeitungskammer Separierelemente vorgesehen, die derart in den Bearbeitungsraum plazierbar sind, dass sie bei einem Werkstoffwechsel und/oder einem Wechsel des Mischungsverhältnisses die Werkstoffe bzw. Werkstoffgemische voneinander trennen. Dazu können die zwischen die einzelnen Werkstoffe einzulegenden Separierelemente schablonenartig ausgebildet sein, um den zu bestrahlenden Bereich der Pulverschicht nicht unnötig zu verdecken.

In einer vorteilhaften Ausgestaltung der erfindungsgemäßen Vorrichtung ist eine Absaugeinrichtung vorgesehen, um nicht verarbeitetes pulverförmiges Material, insbesondere vor einem Wechsel des zuzuführenden Werkstoffes zur Wiederverwendung aus dem Verarbeitungsraum zur Verhinderung einer Vermischung abzusaugen. Natürlich ist es auch möglich, die Absaugeinrichtung erst nach Fertigstellung des Bauteils zu verwenden, um die einzelnen durch die schablonenartigen Separiereinheiten voneinander getrennten Werkstoffe nacheinander abzusaugen.

Eine weitere vorteilhafte Ausgestaltung der Erfindung sieht vor, dass nach Fertigstellung des Bauteils das nicht verarbeitete Pulvermaterial zur Wiederverwendung über eine Aufbereitungseinheit dem Herstellungsprozess wieder zugeführt werden kann. Dazu kann die Aufbereitungseinheit ein Sieb zur Aussortierung von verschmolzenem oder verklumptem Material aufweisen und eine Pulvertrenneinrichtung umfassen. Eine Pulvertrenneinrichtung kann beispielsweise eine einen Magnet enthaltene Anordnung sein. Dies ist sinnvoll, wenn beispielsweise einer der in dem Verfahren eingesetzten Werkstoffe magnetisch ist und der andere nicht. Eine alternative Trenneinrichtung stellt eine Blaseinrichtung dar, die zum Einsatz kommt, wenn Pulver mit sehr unterschiedlicher Dichte zum Einsatz kommen. Durch die Blaseinrichtung können die einzelnen Komponenten getrennt werden, indem das Pulver geringer Dichte aus dem Gemisch ausgeblasen wird.

Weitere vorteilhafte Ausgestaltung der Erfindung sind den Unteransprüchen zu entnehmen sowie der nachfolgenden Beschreibung eines Ausführungsbeispiels anhand der beiliegenden Zeichnung. In der Zeichnung zeigt:
- Figur 1: eine schematische Darstellung eines Mikrokühlkörpers gemäß der Erfindung;
- Figur 2: eine schematische Darstellung einer Vorrichtung zur Herstellung eines Bauteils durch selektives Lasersintern.

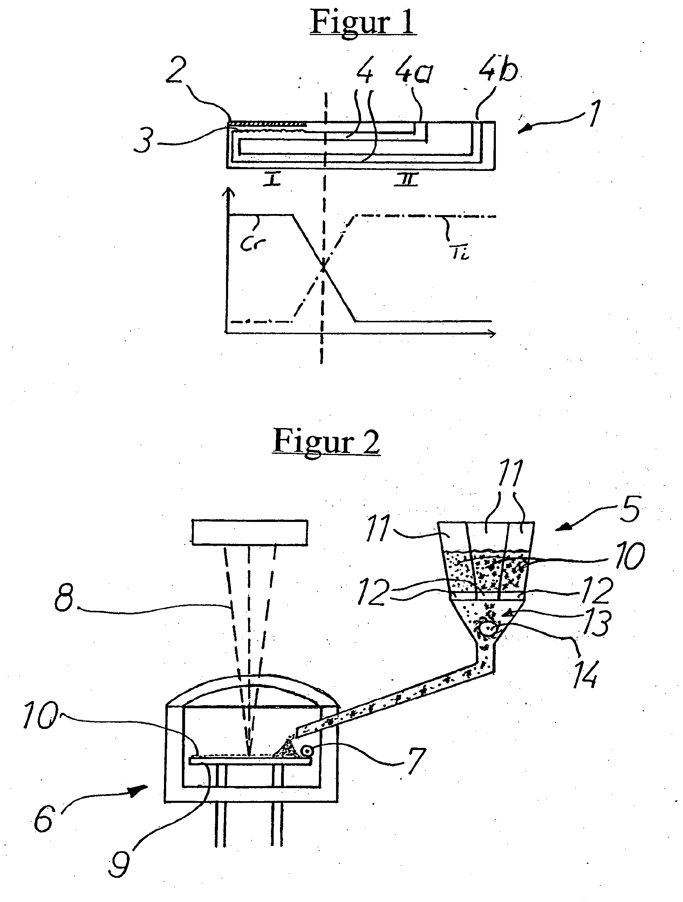

Die Figur 1 zeigt schematisch einen erfindungsgemäßen Mikrokühlkörper, welcher sich grob in zwei Bereiche I und II aufteilen lässt.

Im Bereich I ist an der Oberseite des Mikrokühlkörpers 1 in seinem vorderen stirnseitigen Endbereich eine Montagefläche 2 für ein zu kühlendes Bauteil wie beispielsweise ein Halbleiterbauelement ausgebildet. Unterhalb der Montagefläche 2 ist in Inneren des Mikrokühlkörpers 1 eine Mikrokühlstruktur 3 angeordnet, die über Verbindungskanäle 4 mit im Bereich II befindlichen Zu- und Ablauföffnungen 4a, 4b einen Kühlkreislauf bildet, welcher zu Kühlzwecken mit einem Kühlmedium, wie beispielsweise deionisiertem Wasser, durchströmt werden kann. Im Bereich I, insbesondere im Bereich der Mikrokühlstruktur 3, steht die Forderung eines optimalen Wärmeaustauschs im Vordergrund. Dementsprechend ist in diesem Bereich ein möglichst erosionsfreier und ausdehnungsangepasster Werkstoff mit guten Kühleigenschaften wünschenswert. Ein Beispiel eines solchen Werkstoffs ist Chrom. Jedoch können auch Werkstoffe wie beispielsweise Nickel möglich. Werkstoffeigenschaften wie beispielsweise Stabilität spielen an dieser Stelle eine untergeordnete Rolle, da nur geringe mechanische Belastungen auftreten und sind hier daher vernachlässigbar.

Im Bereich II hingegen sind gerade im Bereich des Wassereinlasses und des Wasserauslasses die mechanischen Beanspruchungen sehr groß. Auch im Bereich der Zu- bzw. Abführung des Kühlwassers treten relativ hohe mechanische Belastungen auf. Daher ist es in diesem Bereich wünschenswert, einen Werkstoff mit großer Beständigkeit gegenüber Elektrokorrosion und mit sehr guter mechanischer Festigkeit wünschenswert. Diese Anforderungen werden beispielsweise durch Einsatz von Titan realisiert. Auch Werkstoffe wie beispielsweise Edelstahl sind hier einsetzbar. Die gegenüber dem Chrom schlechtere Wärmeleitfähigkeit und Ausdehnungsanpassung ist in diesem Bereich von untergeordneter Bedeutung, da dieser Bereich nicht am direkten Wärmeaustausch mit dem zu kühlenden Bauteil beteiligt ist.

Zwischen Bereich I und Bereich II ist ein Übergangsbereich Ü vorgesehen, in dem von Bereich I zu Bereich II gesehen das Mischungsverhältnis kontinuierlich derart verändert wird, daß der Chromgehalt abnimmt und der Titangehalt entsprechend zunimmt, je mehr man vom Bereich I in Richtung des Bereichs II wandert. Durch die kontinuierliche Mischung der beiden Materialien wird ein homogener Übergang geschaffen, mit dem es möglich ist, die Werkstoffe, die sich nur schlecht direkt verbinden lassen, miteinander zu verbinden. Bei Inkompabilität bietet es sich ggf. an, eine sogenannte Vermittlerkomponente zwischen die Werkstoffe zwischenzuschalten.

Unterhalb des schematisch dargestellten Mikrokühlkörpers 1 ist zur Veranschaulichung die Veränderung des Chrom- und Titangehalts in den jeweiligen Bereichen des Kühlkörpers schematisch dargestellt. Als Ergebnis erhält man einen Kühlkörper, welcher im Bereich des Wärmeaustauschs erosionsfrei, ausdehnungsangepasst und mit guten Kühleigenschaften versehen ist. Im Bereich der Zuführung bzw. Abfuhr verfügt der Kühlkörper über eine hervorragende Beständigkeit gegenüber Elektrokorrosion und über sehr gute mechanische Festigkeit.

Der Mikrokühlkörper 1 wird wie bereits erwähnt vorliegend mittels des selektiven Laserschmelzens hergestellt. Bei diesem Verfahren wird das herzustellende Bauteil zunächst entlang der Z-Ebene des Bauteils virtuell in Schnitte zerlegt, und die sich daraus ergebenden CAD-Daten in X- und Y-Richtung werden in eine Steuereinheit eingegeben. Ferner wird das Bauteil dahingehend analysiert, in welchen Bereichen welche Eigenschaften zu priorisieren sind, um danach eine Werkstoffauswahl zu treffen. Der erfindungsgemäße Mikrokühlkörper 1 kann vorliegend in zwei Anforderungsbereiche aufgeteilt werden. Bereich I betrifft wie oben beschrieben den Teil des Kühlkörpers 1, für den der Abtransport der Wärme maßgeblich ist, da in diesem Bereich der zu kühlende Halbleiter montiert werden soll.

Somit sind hier die wesentlichen zu fordernden Eigenschaften an den Werkstoff Wärmeleitfähigkeit, Ausdehnungsanpassung an das zu kühlende Bauelement und die Erosionsbeständigkeit. Elektrokorrosion und mechanische Beanspruchung spielen hier nur eine untergeordnete Rolle. Im Bereich II befinden sich die Anschlussstellen 4a, 4b für die Wasserversorgung. Da der Kühlkörper 1 auch Bestandteil der elektrischen Kontaktierung ist, liegt hier der Schwerpunkt auf mechanischer Stabilität und Beständigkeit gegen Elektrokorrosion. Anforderungen wie Wärmeleitfähigkeit und Ausdehnungsanpassung sind hier untergeordnete Anforderungen an den Werkstoff.

Zum Aufbau des erfindungsgemäßen Mikrokühlkörpers 1 wird aufgrund der vorangegangenen Analyse zunächst zur Ausbildung des Bereichs I ein Werkstoff mit guter Wärmeleitfähigkeit und an das zu kühlende Bauteil angepassten Wärmeausdehnungskoeffizienten ausgewählt und über einen in Figur 2 gezeigten Speiser 5 in einen Bearbeitungsbereich einer Bearbeitungskammer 6 eingebracht und anschließend mittels einer Nivelliereinrichtung 7 frei von Bindemitteln und Flussmitteln mit einer vorgegebenen Schichthöhe, die einer Eindringtiefe eines in dem Verfahren eingesetzten Laserstrahls 8 entspricht, auf eine in Z-Richtung versenkbare Bodenplatte 9 der Bearbeitungskammer 6 verteilt. Unter Schutzgasatmosphäre wird der Laserstrahl 8 entsprechend der in die Steuereinheit eingegebenen CAD-Daten auf der Pulverschicht 10 verfahren, so dass das metallische Werkstoffpulver 10 lokal auf Schmelztemperatur erhitzt und an der jeweiligen Auftreffstelle des Laserstrahls 8 über seine gesamte Schichthöhe vollständig aufgeschmolzen wird. Anschließend wird die Bodenplatte 9 um einen Betrag abgesenkt, der der Schichtdicke des aufgeschmolzenen Metallpulvers 10 entspricht. Dann wird eine weitere Schicht aus dem metallischen Werkstoffpulver 10 auf die bereits vorhandene, mit Laserstrahlung behandelte Metallpulverschicht 10 aufgebracht, deren Schichtdicke wiederum der Eindringtiefe des Laserstrahls 8 entspricht.

Die Zufuhr des Werkstoffpulvers 10 erfolgt über den erfindungsgemäßen Speiser 5, in dem in diesem Ausführungsbeispiel drei Materialkammern 11 ausgebildet sind. Die eine Materialkammer 11 ist hier für Bestückung des Bereichs I mit Chrom Cr, die andere für Bereich II mit Titan Ti gefüllt, die dritte Materialkammer 11 ist mit einer Chrom-Titan-Mischung bestückt.

Auslassseitig sind die Materialkammern 11 jeweils mit einer Dosiereinheit 12 versehen, über die das Mischungsverhältnis und die Zuführmenge der einzelnen Werkstoffe 10 durch einfaches Öffnen und Schließen der auslassseitigen Öffnung in der Materialkammer 11 einstellbar sind, indem die Dosiereinheiten 12 zur Zuführung des Werkstoffs zu der Bearbeitungskammer 6 den Werkstoffauslass der Materialkammer 11 freigeben, wodurch sich das Werkstoffpulver 10 aufgrund von Schwerkraft aus den Materialkammern 11so lange herausbewegt, bis die Dosiereinheiten 12 wieder schließen. Die Dosiereinheiten 12 sind in dieser Ausführungsform zur Einstellung eines vorgebbaren Mischungsverhältnisses computergesteuert, was eine sehr genaue Einstellung der Zusammensetzung des Werkstoffgemischs 10 zur Folge hat.

Um eine möglichst homogene Durchmischung des Werkstoffgemischs zu erhalten, ist hier eine Mischkammer 13 den dosiereinheiten 12 nachgeschaltet, in der das Probengemisch vor Zuführung zu der Prozesskammer noch einmal intensiv mittel einer Schnecke 14 durchmengt werden kann. Zur Schaffung einer möglichst homogenen Übergangszone zwischen den beiden verschiedenartigen Werkstoffen zu schaffen, wird das Mischungsverhältnis der Werkstoffe Chrom und Titan vor der Zufuhr in den Bearbeitungsbereich in der Bearbeitungskammer 6 von Schichtauftrag zu Schichtauftrag stufenweise oder auch kontinuierlich verändert. Der Speiser 5 weist in diesem Ausführungsbeispiel eine weitere Materialkammer 11 auf, die in diesem Ausführungsbeispiel mit einem Chrom-Titan-Werkstoffgemisch bestückt ist, aber im Fall miteinander völlig inkompatibler Werkstoffe auch mit einer nicht dargestellten Vermittlerkomponente bestückt werden kann, die dann in dem Übergangsbereich zur Verbindung der Werkstoffe zwischengeschaltet werden kann. Es ist auch denkbar, die dritte Werkstoffkammer mit einem für die Übergangszone optimalen Werkstoffgemisch mit einem weiteren von Chrom und Titan unterschiedlichen Werkstoff zu befüllen, welches im Vorfeld außerhalb der Vorrichtung schon angefertigt werden kann. Dies ist dann vorteilhaft, wenn auch der Übergangsbereich ein konstantes Mischungsverhältnis fordert oder der Vermittlerwerkstoff nur einen sehr geringen Anteil in einem nur sehr kleinen Einsatzgebiet darstellt.

Zur Ausbildung des Werkstücks wird der Laserstrahl 8 nun in mehreren Spuren über den vorgegebenen Bereich der Werkstoffschichten 10 so geführt, dass jede folgende Spur des Laserstrahls die vorherige Spur zumindest teilweise überlappt. Durch die Überlappung wird die Schmelze des Pulvers 10 und die Schmelze der angrenzenden, bereits erstarrten festen Kontur, die zuvor aufgeschmolzen wurde, und unter der nachträglich aufgetragenen Pulverschicht, zu einem gemeinsamen Schmelzbad aufgeschmolzen. Daraufhin geht das Schmelzbad eine schmelzmetallurgische Verbindung ein. Dadurch bildet sich nach der Erstarrung eine homogene Gitterstruktur mit hoher Festigkeit und Dichtigkeit und ohne Rillen oder sonstige Übergangsstellen aus.

Wurde auf diese Weise der Mikrokühlkörper 1 mit den zwei Hauptbereichen I, II vollständig aufgebaut, ist es anschließend lediglich notwendig, das in den inneren Strukturen zurückgebliebene Pulver zu entfernen. Dies kann beispielsweise mittels Druckluft erreicht werden oder indem der Mikrokühlkörper anschließend mit deionisiertem Wasser unter Druck durchspült wird.

Da mittels dieses Verfahrens die unterschiedlichsten metallischen Werkstoffpulver auch in Kombination bearbeitet werden können, ist neben der Kombination von metallischen Werkstoffen auch eine Kombination von metallischen und keramischen Werkstoffen denkbar. Auch die Verwendung von flüssigen metallischen oder keramischen Werkstoffen ggf. auch in Kombination mit pulverförmigen Werkstoffen, ist denkbar.

## Patentansprüche

1. Mikrokühlkörper (1) mit einer Montagefläche (2) für ein zu kühlendes Bauteil, insbesondere ein Halbleiterbauelement, welcher im Inneren eine Mikrokühlstruktur (3) aufweist, die über Verbindungskanäle (4) mit mindestens einer Zulauföffnung (4a) und mindestens einer Ablauföffnung (4b) verbunden ist, über die der Mikrokühlstruktur (3) ein Kühlmedium zuführbar bzw. aus ihr abführbar ist, **dadurch gekennzeichnet, dass** er aus mindestens zwei verschiedenartigen, durch Aufschmelzung und Erstarrung miteinander fixierten pulverförmigen und/oder flüssigen Werkstoffen oder Werkstoffgemischen (10) unter Beibehaltung einer monolithischen Struktur gebildet ist, wobei ein erster Werkstoff oder ein erstes Werkstoffgemisch (10) ein thermisch leitfähiger pulverförmiger oder flüssiger Werkstoff oder Werkstoffgemisch (10) ist, und in einem ersten vorwiegend thermisch beanspruchten Bereich (I) des Mikrokühlkörpers (1) angeordnet ist und ein zweiter, vom ersten Werkstoff oder Werkstoffgemisch verschiedenartiger pulverförmiger oder flüssiger, Werkstoff oder ein zweites Werkstoffgemisch (10) eine hohe Festigkeit aufweist und in einem mechanisch beanspruchten Bereich (II) des Mikrokühlkörpers (1) angeordnet ist.

2. Mikrokühlkörper nach Anspruch 1, **dadurch gekennzeichnet, dass** der erste Werkstoff oder das erste Werkstoffgemisch und der zweite Werkstoff oder das zweite Werkstoffgemisch ein metallischer oder keramischer Werkstoff oder eine Mischung daraus ist.

3. Mikrokühlkörper nach Anspruch 1 oder 2, **dadurch gekennzeichnet, dass** der erste Werkstoff oder das erste Werkstoffgemisch Chrom oder Nickel ist.

4. Mikrokühlkörper nach einem der Ansprüche 1 bis 3, **dadurch gekennzeichnet, dass** der zweite Werkstoff oder das zweite Werkstoffgemisch Titan oder Edelstahl ist.

5. Mikrokühlkörper nach einem der vorhergehenden Ansprüche, **dadurch gekennzeichnet, dass** zur Schaffung eines homogenen Übergangs zwischen zwei verschiedenartigen, pulverförmigen oder flüssigen Werkstoffen oder Werkstoffgemischen (10) ein Mischungsverhältnis dieser Werkstoffe bzw. Werkstoffgemische von Schichtauftrag zu Schichtauftrag stufenweise oder kontinuierlich zu- bzw. abnimmt.

6. Mikrokühlkörper nach einem der vorhergehenden Ansprüche, dadurch gekenntzeichnet, dass zur Verbindung zweier verschiedenartiger, insbesondere miteinander inkompatibler Werkstoffe oder Werkstoffgemische ein Vermittlerwerkstoff zwischen die verschiedenartige Werkstoffe einsetzbar bzw. eingesetzt ist.

7. Vorrichtung zur Herstellung eines Mikrokühlkörpers (1) nach mindestens einem der Ansprüche 1 bis 6, durch schichtweisen Aufbau von mindestens zwei verschiedenartigen, pulverförmigen oder flüssigen, insbesondere metallischen und/oder keramischen Werkstoff en oder Werkstoff gemi sehen (10) mit
- einer Bearbeitungskammer (6), in der ein Bearbeitungsraum ausgebildet ist, in den die Werkstoffe oder Werkstoffgemische (10) über mindestens einen Speiser (5) einbringbar sind,
- mindestens einer Strahlungsquelle (8), deren Strahlung in den Bearbeitungsraum einkoppelbar ist,
**dadurch gekennzeichnet, dass** der Speiser (5) mehrere Materialkammern (11) aufweist, die mit jeweils einem Werkstoff oder Werkstoffgemisch (10) befüllt sind und denen auslassseitig jeweils eine Dosiereinheit (12) zugeordnet ist, über die ein Mischungsverhältnis und/oder eine Zuführmenge der Werkstoffe oder Werkstoffgemische (10) zum Bearbeitungsraum eingestellt und anschließend über eine Verbindungsleitung dem Bearbeitungsraum zuführbar ist.

8. Vorrichtung zur Herstellung eines Mikrokühlkörpers nach Anspruch 7, **dadurch gekennzeichnet, dass** den Dosiereinheiten (12) zur Durchmischung des Werkstoffes oder Werkstoffgemisches (10) mindestens eine Mischkammer (13) nachgeschaltet ist.

9. Vorrichtung zur Herstellung eines Mikrokühlkörpers nach Anspruch 7 oder 8, **dadurch gekennzeichnet, dass** zur Schaffung eines homogenen Übergangs zwischen zwei verschiedenartigen Werkstoffen oder Werkstoffgemischen (10) das Mischungsverhältnis der zuzuführenden Materialien vor der Zufuhr in den Bearbeitungsraum von Schichtauftrag zu Schichtauftrag stufenweise oder kontinuierlich verändert wird.

10. Vorrichtungzur Herstellung eines Mikrokühlkörpers nach einem der Ansprüche 7 bis 9, **dadurch gekennzeichnet, dass** in der Bearbeitungskammer (6) Separierelemente vorgesehen sind, die derart in den Bearbeitungsraum platzierbar sind, dass sie bei einem Werkstoffwechsel und/oder einem Wechsel des Mischungsverhältnisses die Werkstoffe (10) voneinander trennen.

11. Vorrichtung zur Herstellung eines Mikrokühlkörpers nach einem der Ansprüche 7 bis 10, **dadurch gekennzeichnet, dass** eine Absaugeinrichtung vorgesehen ist, um nicht verarbeiteten pulverförmigen und/oder flüssigen Werkstoff (10) insbesondere vor einem Wechsel des zuzuführenden Werkstoffes zur Wiederverwendung aus dem Bearbeitungsraum abzusaugen.

12. Vorrichtung zur Herstellung nach einem der Ansprüche 7 bis 11, **dadurch gekennzeichnet, dass** zur Wiederverwendung des nicht verarbeiteten pulverförmigen u8nd/öder flüssigen Werkstoffes (10) eine Aufbereitungseinheit vorgesehen ist, die ein Sieb und/oder eine Pulvertrenneinrichtung umfasst.

13. Verfahren zur Herstellung eines Mikrokühlkörpers (1) nach einem der Ansprüche 1 bis 6, durch schichtweisen Aufbau aus mindestens zwei verschiedenartigen pulverförmigen oder flüssigen, insbesondere metallischen und/oder keramischen Werkstoffen (10), enthaltend die Schritte:
1. Einbringen eines ersten möglichst erosionsfreien und ausdehnungsangepassten Werkstoffes oder Werkstoffgemisches (10) mit guten Kühleigenschaften in eine Bearbeitungskammer (6);
2. Verteilen des Werkstoffes oder Werkstoffgemisches (10) auf einen Bearbeitungsbereich insbesondere mittels einer Nivelliervorrichtung unter Bildung einer gleichmäßigen Schicht;
3. Bestrahlen des Bearbeitungsbereiches zur Aufschmelzung und Fixierung des ersten Werkstoffes oder Werkstoffgemisches (10) in einem ersten thermisch beanspruchten Bereich (I) des Mikrokühlkörpers (1) an der darunter liegenden Schicht;
4. Absenken des Bearbeitungsbereichs; und
5. Wiederholen der Schritte 1 bis 4
**dadurch gekennzeichnet, dass** zur Ausbildung eines zweiten vorwiegend mechanisch beanspruchten Bereichs (II) dem Bearbeitungsbereich ein zweiter vom ersten Werkstoff oder Werkstoffgemisch (10) verschiedenartiger Werkstoff oder Werkstoffgemisch (10) mit großer Beständigkeit gegen Elektrokorrosion und mit sehr guter mechanischer Festigkeit zugeführt wird, um in dem zweiten Bereich (II) aufgeschmolzen und an einer darunterliegenden Schicht fixiert zu werden.

14. Verfahren nach Anspruch 13, **dadurch gekennzeichnet, dass** zur Schaffung eines homogenen Übergangs zwischen dem ersten und dem zweiten Werkstoff oder Werkstoffgemisch (10) das Mischungsverhältnis der zuzuführenden Werkstoffe oder Werkstoffgemische (10) vor der Zufuhr in den Bearbeitungsbereich von Schichtauftrag zu Schichtauftrag stufenweise oder kontinuierlich verändert wird.

15. Verfahren nach Anspruch 13 oder 14, **dadurch gekennzeichnet, dass** zur Verbindung zweier verschiedenartiger insbesondere miteinander inkompatibler Werkstoffe öder Werkstoffgemische (10) ein Vermittlerwerkstoff kontinuierlich oder stufenweise dem Bearbeitungsbereich zugeführt wird.

## Claims

1. A micro cooling element (1) with a mounting surface (2) for a component to be cooled, in particular a semiconductor component, which has within it a micro cooling structure (3) which is connected by connection channels (4) to at least one inflow opening (4a) and at least one outflow opening (4b) by means of which a cooling medium can be supplied to the micro cooling structure (3) or be discharged from the latter, **characterised in that** it is formed from at least two different powdery and/or liquid, in particular metallic and/or ceramic materials or material mixtures (10) while maintaining a monolithic structure, wherein a first material or a first material mixture (10) is a thermally leading powdery or liquid material or material mixture (10) and is provided in a first predominant thermally stressed region (I) of the micro cooling element, and a second powdery or liquid material or material mixture (10), which is different from the first material or material mixture has a high mechanical strength and it provided in a mechanically stressed region (II) of the micro cooling element (1).

2. Micro cooling element according to claim 2 **characterised in that** the first material or the first material mixture and the second material or the second material mixture are metallic or ceramic materials or a mixture thereof.

3. Micro cooling element according to claim 1 or 2, **characterised in that** the first material or the first material mixture is chromium or nickel.

4. Micro cooling element according to any of the claims 1 to 3, **characterised in that** the second material or the second material mixture is titanium or stainless steel.

5. Micro cooling element according to any preceding claims, **characterised in that** for creating homogenious crossover between two different powdery or liquid materials or material mixtures (10) the mix ratio of these materials or material mixtures, respectively, increases or decreases continuously or in a step wise manner from layer application to layer application.

6. Micro cooling element according to any preceding claims, **characterised in that** for linking two different, in particular incompatible materials or material mixtures a mediator material is inserted or insertable between the different materials.

7. An apparatus for producing a micro cooling element (1) according to at least one of the claims 1 to 6, by means of a layered structure of at least two different powdery or liquid, in particular metallic and/or ceramic materials or material mixtures (10) with
- a processing chamber (6) in which a processing space is formed into which the materials or material mixtures (10) can be introduced by at least one feeder (5),
- at least one radiation source (8) the radiation of which can be coupled into the processing space,
**characterised in that** the feeder (5) has a number of material chambers (11) which are respectively filled with a material or material mixture (10) and to which a dosing unit (12) is respectively assigned on the outlet side by means of which a mix ratio and/or a supply quantity of the materials or material mixtures (10) to the processing space can be set and subsequently be supplied to the processing chamber via a connecting line.

8. Apparatus for producing a micro cooling element according to Claim 7, **characterised in that** at least one mixing chamber (13) is located downstream of the dosing units (12) for the mixing of the material or material mixture (10).

9. Apparatus for producing a micro cooling element according to Claims 7 to 8, **characterised in that** in order to create a homogeneous crossover between two different materials or material mixtures (10), the mix ratio of the materials to be supplied can be changed step by step or continuously from layer application to layer application before being supplied to the processing space.

10. Apparatus for producing a micro cooling element according to Claim 7 to 8, **characterised in that** in the processing chamber (6) separation elements are provided which can be positioned in the processing space such that with a change to the material and/or a change to the mix ratio they separate the materials (10) from one another.

11. Apparatus for producing a micro cooling element according to Claim 7 to 10, **characterised in that** a suction device is provided in order to draw off from the processing space any powdery and/or liquid material (10) not processed, in particular before changing the material to be supplied, for reuse.

12. Apparatus for producing a micro cooling element according to Claim 7 to 11, **characterised in that** for reuse of the powdery and/or liquid material (10) not processed, a preparation unit is provided which comprises a sieve and/or a powder separation device.

13. A process for producing a micro cooling element (1) according to any of the Claims 1 to 6, by means of a layered structure comprising at least two different powdery and/or liquid, in particular metallic and/or ceramic materials (10), including the steps:
- 1. introducing a material or material mixture (10) into a processing chamber (6);
- 2. distributing the material or material mixture(10) over a processing region, in particular by means of a levelling device such as to form an even layer;
- 3. irradiation of the processing region in order to fuse and fix the material or material mixture(10) in a first terminally stressed region (I) of the micro cooling element (1) on the layer lying beneath;
- 4. lowering of the processing region; and
- 5. repetition of steps 1 to 4
**characterised in that** for creating a second predominant mechanically stressed region (II) a second material or material mixture (10) different from the first material or material mixture (10) is supplied to the processing region with a high resistance against electro corrosion and with a very good mechanical stability, in order to be fused and fixed to a layer lying beneath.

14. The process according to Claim 13, **characterised in that** in order to create a homogeneous crossover between the first and second materials or material mixtures (10) the mix ratio of the materials or material mixtures (10) to be supplied are changed step by step or continuously from layer application to layer application before supplying to the processing region.

15. The process according to Claim 13 or 14, **characterised in that** in order to combine two different materials or material mixtures (10), in particular ones which are incompatible with one another, a mediator material is supplied continuously or step by step to the processing region.

## Revendications

1. Corps de refroidissement (1) avec une surface de montage (2) pour un composant à refroidir, en particulier un élément semi-conducteur à l'intérieur duquel se trouve une structure micro-réfrigérante (3) connectée via des canaux de raccord (4) à au moins une ouverture d'introduction (4a) et à au moins une ouverture d'évacuation (4b) via lesquelles un fluide réfrigérant peut entrer dans ou sortir de la structure micro-réfrigérante (3), **caractérisé en ce qu'** il est composé d' au moins deux sortes différentes de matériaux ou de mélanges de matériaux (10) en poudre ou liquides fixés l' un à l'autre par fusion et solidification en obtenant une structure monolithique, un premier matériau ou un premier mélange de matériaux (10) étant un matériau ou mélange de matériau (10) conducteurs thermiques en poudre ou en liquide disposé dans une zone (I) du corps de refroidissement (1) essentiellement sous sollicitation thermique, et un deuxième matériau ou mélange de matériaux (10) présentant une haute résistance et étant disposé dans une zone (II) du corps de refroidissement (1) essentiellement sous sollicitation mécanique.

2. Corps de refroidissement selon la revendication 1, **caractérisé en ce que** le premier matériau ou le premier mélange de matériaux et le deuxième matériau ou le deuxième mélange de matériaux sont des matériaux métalliques ou céramiques, ou un mélange de ces derniers.

3. Corps de refroidissement selon les revendications 1 ou 2, **caractérisé en ce que** le premier matériau ou mélange de matériaux est du chrome ou du nickel.

4. Corps de refroidissement selon l'une des revendications 1 à 3, **caractérisé en ce que** le deuxième matériau ou mélange de matériaux est du titane ou du de l'acier inoxydable.

5. Corps de refroidissement selon l'une des revendications précédentes, **caractérisé en ce que** pour favoriser une transition homogène entre deux sortes de matériaux ou mélanges de matériaux (10) en poudre ou liquides, un rapport de mélange de ces matériaux ou mélanges de matériaux augmente ou diminue de façon progressive ou continue de l' application d' une couche à l'autre.

6. Corps de refroidissement selon l'une des revendications précédentes, **caractérisé en ce que** pour relier deux sortes différentes et notamment incompatibles de matériaux ou de mélanges de matériaux, un matériau intermédiaire est ou peut être posé entre les deux matériaux.

7. Dispositif pour la production d' un corps de refroidissement (1) selon au moins l'une des revendications 1 à 6 par la mise en place en couches d' au moins deux sortes de matériaux ou mélanges de matériaux (10) en poudre ou liquides, plus spécifiquement métalliques ou céramiques, avec
- une chambre de traitement (6) contenant un espace de traitement dans lequel les matériaux ou mélanges de matériaux (10) sont introduits via un alimentateur (5),
- au moins une source de rayonnement (8) dont le rayonnement peut être introduit dans l'espace de traitement,
**caractérisé en ce que** l'alimentateur (5) présente plusieurs chambres de matériaux (11) qui sont chacune remplies d' un matériau ou mélange de matériaux (10) et assignées du côté sortie à une unité de dosage (12) par laquelle est réglé un rapport de mélange et/ou un débit de matériaux ou mélanges de matériaux (10) vers l'espace de traitement, puis acheminé à l'espace de traitement via un raccord.

8. Dispositif pour la production d' un corps de refroidissement selon la revendication 7, **caractérisé en ce qu'** au moins une chambre de mélange (13) est positionnée en aval des unités de dosage (12) pour le mélange du matériau ou mélange de matériaux (10).

9. Dispositif pour la production d' un corps de refroidissement selon les revendications 7 ou 8, **caractérisé en ce que** pour favoriser une transition homogène entre deux sortes de matériaux ou mélanges de matériaux (10) en poudre ou liquides, un rapport de mélange de ces matériaux ou mélanges de matériaux augmente ou diminue de façon progressive ou continue de l' application d' une couche à l'autre.

10. Dispositif pour la production d' un corps de refroidissement selon l'une des revendications 7 à 9, **caractérisé en ce que** la chambre de traitement (6) contient des éléments séparateurs pouvant être disposés dans l'espace de traitement de à séparer les matériaux (10) lorsqu' un matériau est changé ou que le rapport de mélange est changé.

11. Dispositif pour la production d' un corps de refroidissement selon l'une des revendications 7 à 10, **caractérisé en ce qu'** un dispositif d' aspiration est en place pour évacuer de l'espace de traitement avant un changement du matériau alimentés les matériaux (10) en poudre ou liquides qui n' ont pas été traités en vue d' une utilisation ultérieure.

12. Dispositif de production selon l'une des revendications 7 à 11, **caractérisé en ce qu'** une unité de préparation comprenant un tamis et/ou un dispositif de séparation de la poudre en vue de la réutilisation des matériaux (10) en poudre ou liquide.

13. Procédé pour la production d' un corps de refroidissement (1) selon l'une des revendications 1 à 6 par la mise en place en couches d' au moins deux sortes de matériaux ou mélanges de matériaux (10) en poudre ou liquides, plus spécifiquement métalliques ou céramiques, comprenant les étapes suivantes :
1. Introduction d' un premier matériau ou mélange de matériaux (10) idéalement sans érosion et à coefficient de dilatation adapté avec de bonnes capacités de refroidissement dans la chambre de traitement (6) ;
2. Distribution du matériau ou mélange de matériaux (10) sur une surface de traitement, notamment au moyen d' un dispositif de nivellement, en formant une couche égale ;
3. Irradiation de la surface de traitement pour la fusion et la fixation du premier matériau ou mélange de matériaux (10) dans une première zone (I) sous sollicitation thermique du corps de refroidissement (1) à la couche sous-jacente ;
4. Abaissement de la surface de traitement ; et
5. Répétition des étapes 1 à 4
**caractérisé en ce qu'** en vue de la formation d' une seconde zone (II) essentiellement sous sollicitation mécanique, un deuxième matériau ou mélange de matériaux (10) différent du premier matériau ou mélange de matériaux (10) et avec une excellente résistance contre l' électroérosion ainsi qu' une très bonne résistance mécanique est introduit dans l'espace de traitement afin d' être fondu dans la seconde zone (II), puis fixé à une couche sous-jacente.

14. Procédé selon la revendication 13, **caractérisé en ce qu'** en vue de favoriser une transition homogène entre le premier et le deuxième matériau ou mélanges de matériaux (10), le rapport de mélange de ces matériaux ou mélanges de matériaux (10) à introduire est modifié de façon progressive ou continue avant l' introduction dans l'espace de traitement de l' application d' une couche à l'autre.

15. Procédé selon les revendications 13 ou 14, **caractérisé en ce que** pour relier deux sortes différentes et notamment incompatibles de matériaux ou de mélanges de matériaux (10), un matériau intermédiaire est introduit dans l'espace de traitement de façon progressive ou continue.
